# EUROPEAN PATENT APPLICATION

(11) **EP 4 779 817 A1**
(43) Date of publication of application: **22.07.2026**
(21) Application number: 24878827.5
(22) Date of filing: 27.09.2024
(51) Int. Cl.: H01R 39/08, H01R 13/52, H01L 21/687, H01L 21/67

(54) **CONDUCTIVE SLIP RING AND SEMICONDUCTOR PROCESS DEVICE**

(30) Priority: 19.10.2023 CN 202311360824
(71) Applicant: Beijing NAURA Microelectronics Equipment Co., Ltd., Beijing 100176 (CN)
(72) Inventor: YU, Bin, Beijing 100176 (CN); YE, Hua, Beijing 100176 (CN); SHI, Quanyu, Beijing 100176 (CN)
(74) Representative: Cohausz & Florack
(86) International application number: PCT/CN2024/121661
(87) International publication number: WO 2025/082181

(57) **Abstract**

The present disclosure discloses a conductive slip ring and semiconductor process equipment. The disclosed conductive slip ring is applied to a process chamber of the semiconductor process equipment. The conductive slip ring includes a housing, a stationary electrical connection part, and a rotary electrical connection part. The housing includes a housing cavity and a first mounting hole communicating with the housing cavity. The housing is configured to be sealingly connected to the process chamber, so that the housing cavity is in sealed connection with a chamber space of the process chamber. The stationary electrical connection part is in sealing engagement with the first mounting hole, and a first end of the stationary electrical connection part extends into the housing cavity and is rotatably electrically connected to the rotary electrical connection part, a second end of the stationary electrical connection part is located outside the housing and configured to be electrically connected to a power supply. The rotary electrical connection part is rotatably disposed within the housing and configured to be electrically connected to an electrical device within the process chamber. The above solution can solve the problem of poor sealing performance in related technologies where the process chamber uses magnetohydrodynamic structures to achieve sealing between the process space and the external environment of the process chamber.

## Description

### TECHNICAL FIELD

The present disclosure generally relates to the technical field of semiconductor process equipment and, more particularly, to a conductive slip ring and semiconductor process equipment.

### BACKGROUND

In film deposition processes, a carrier, while supporting a wafer, rotates the wafer to obtain a thin film with relatively uniform thickness. However, besides supporting function, the carrier also has other functions such as heating and radio frequency (RF) functions. To achieve some of these functions, power needs to be supplied to the rotating carrier so that the electrical devices within carrier can operate. Therefore, rotary power supply technology is a core technology for realizing some of the carrier's functions.

Since the carrier is located within the process space of the process chamber, and the process space needs to maintain a vacuum environment during the process, the power supply is located outside the process chamber. This structure needs electrical devices to pass through the process chamber when electrically connecting to the power supply. To avoid disrupting the vacuum environment of the process space, related technologies use magnetohydrodynamic structures to achieve sealed isolation between the process space and the external environment of the process chamber. However, using magnetohydrodynamic structures for sealing isolation has the problem of poor sealing performance, easily leading to connection between the process space and the external environment of the process chamber, resulting in process failure.

Of course, these problems are not limited to electrical devices within the carrier when using rotary power supply technology; similar or identical technical issues will arise in structures in other areas within the process chamber that need power supply using rotary power supply technology.

### SUMMARY

The present disclosure discloses a conductive slip ring and semiconductor process equipment to solve the problem of poor sealing performance in related technologies where the process chamber uses a magnetohydrodynamic structure to achieve sealing between the process space and the external environment of the process chamber.

To address the aforementioned technical problems, the present disclosure provides the following technical solution:

In a first aspect, embodiments of the present disclosure disclose a conductive slip ring applied to a process chamber of semiconductor process equipment. The conductive slip ring includes a housing, a stationary electrical connection part, and a rotary electrical connection part, where:

The housing includes a housing cavity and a first mounting hole communicating with the housing cavity. The housing is configured to be sealingly connected to the process chamber, so that the housing cavity is in sealed connection with the chamber space of the process chamber;

The stationary electrical connection part is in sealing engagement with the first mounting hole, and a first end of the stationary electrical connection part extends into the housing cavity and is rotatably electrically connected to the rotary electrical connection part. A second end of the stationary electrical connection part is located outside the housing and is configured to be electrically connected to a power supply;

The rotary electrical connection part is rotatably disposed within the housing and is configured to be electrically connected to an electrical device within the process chamber.

In a second aspect, the present disclosure discloses semiconductor process equipment, including a process chamber, a carrier, and the aforementioned conductive slip ring. The carrier is rotatably disposed within the process chamber, and an electrical device is disposed within the carrier. The housing is in sealed connection with the process chamber, and the housing cavity communicates with the chamber space of the process chamber. The rotary electrical connection part is connected to the carrier and electrically connected to the electrical device within the carrier.

The technical solution adopted by the present disclosure achieves the following technical effects:
The conductive slip ring of the present disclosure can realize rotary power supply technology, and through the sealed engagement between the stationary electrical connection part and the first mounting hole, the conductive slip ring can create a sealed isolation between the overall space formed after the housing cavity and the chamber space are connected and the external environment where the power supply is located, ultimately maintaining a vacuum environment within the chamber space. Furthermore, by establishing an electrical connection that allows the stationary electrical connection part and the rotary electrical connection part to rotate relative to each other, the stationary electrical connection part and the rotary electrical connection part can maintain contact electrical connection while the rotary electrical connection part rotates with the electrical device, thereby achieving rotary power supply. The sealing structure of this rotary power supply technology eliminates the need for magnetohydrodynamic structures for sealing, thus avoiding the influence of external magnetic fields on the sealing performance. This overcomes the problem of poor sealing performance caused by external magnetic field interference when using magnetohydrodynamic structures.

### BRIEF DESCRIPTION OF THE DRAWINGS

FIG. 1 is a cross-sectional view of the semiconductor process equipment of the present disclosure from one perspective;
FIG. 2 shows a partial structural schematic diagram of FIG. 1;
FIG. 3 is a partial cross-sectional view of the semiconductor process equipment of the present disclosure from another perspective;
FIG. 4 is a cross-sectional view of the conductive slip ring of the present disclosure from one perspective;
FIG. 5 is a cross-sectional view of the conductive slip ring of the present disclosure from another perspective;
FIGs. 6 and 7 are partial cross-sectional views of the conductive slip ring of the present disclosure;
FIG. 8 is a structural schematic diagram of the housing of the conductive slip ring of the present disclosure;
FIG. 9 is a structural schematic diagram of the insulating shaft of the conductive slip ring of the present disclosure;
FIG. 10 is a structural schematic diagram of the conductive ring of the conductive slip ring of the present disclosure;
FIG. 11 schematically shows the assembly of the partial structure of the insulating shaft, conductive ring, and insulating isolator in the conductive slip ring of the present disclosure;
FIG. 12 is a schematic diagram of FIG. 11 from another perspective;
FIG. 13 is a schematic diagram of the power connector structure of the conductive slip ring of the present disclosure;
FIG. 14 is a structural schematic diagram of the stationary insulating sleeve of the present disclosure;
FIG. 15 is a structural schematic diagram of the assembly of the brush and mounting bracket in the conductive slip ring of the present disclosure;
FIG. 16 is a structural schematic diagram of the assembly of the brush, mounting bracket, and stationary insulating sleeve in the conductive slip ring of the present disclosure.

### Reference numerals:

10-Process chamber, 11-Chamber space,
20-Carrier, 21-Electrical device, 22-Support shaft,
01-Conductive slip ring, 30-Housing, 31-Housing cavity, 32-First mounting hole, 33-First plane, 34-Second positioning groove, 35-Connection flange, 36-Mounting groove, 37-Second threaded connector, 38-Mating interface,
40-Stationary electrical connection part, 41-Brush, 42-Power connector, 421-Electrical conductor, 422-Sealing part, 401-Insulation part, 402-Compression part, 412-External threaded connection sleeve, 413-Compression body, 403-First sealing ring, 43-Mounting bracket, 431-Groove-shaped body, 432-Connection fin, 433-Electrical connection protrusion, 4331-Electrical connection hole,
50-Rotary electrical connection part, 51-Insulating shaft, 511-Electrical terminal clearance groove, 52-Conductive ring, 521-Annular body, 522-Electrical terminal, 53-Insulating isolation member, 501-First shaft segment, 502-Second shaft segment,
60-Power supply,
70-Stationary insulating sleeve, 71-Second mounting hole, 72-Annular isolation protrusion, 73-Second plane, 74-First curved surface, 75-Insulating sealing filling part, 76-First positioning groove, 77-Positioning member, 78-First threaded connector,
81-Drive motor, 82-Rotating shaft, 83-Driving wheel, 84-Conveyor belt, 85-Driven wheel, 86-Third bearing,
91-First bearing, 92-Second bearing.

### DETAILED DESCRIPTION OF THE EMBODIMENTS

To make the objectives, technical solutions, and advantages of the present disclosure clearer, the technical solutions of the present disclosure will be described below in conjunction with specific embodiments and corresponding drawings. Obviously, the described embodiments are only some of the embodiments of the present disclosure, and not all of them. All other embodiments obtained by those skilled in the art based on the embodiments of the present disclosure without inventive effort are within the scope of the present disclosure.

In related technologies, semiconductor process equipment uses rotary power supply technology to achieve electrical connection between the electrical devices inside the process chamber and the power supply outside the process chamber. To ensure a vacuum environment inside the process chamber, the rotary power supply technology uses a magnetohydrodynamic (magnetohydrodynamic) structure to achieve sealing, thereby isolating the external environment outside the process chamber. The inventors of the present disclosure discovered that the magnetohydrodynamic structure is highly susceptible to interference from external magnetic fields, and the process chamber is equipped with structures that easily generate external magnetic fields. For example, the radio frequency (RF) coils configured in the process chamber generate magnetic fields during operation (this magnetic field can be considered as an external magnetic field affecting the magnetohydrodynamic structures). Interference from external magnetic fields affects the magnetohydrodynamic structures, thus affecting the sealing performance, ultimately leading to a poor sealing performance between the inside of the process chamber and the external environment outside the process chamber.

Based on this, the inventors of the present disclosure have improved the technical solution to solve the problem of poor sealing performance. The technical solutions disclosed in various embodiments of the present disclosure are described in detail below with reference to the accompanying drawings.

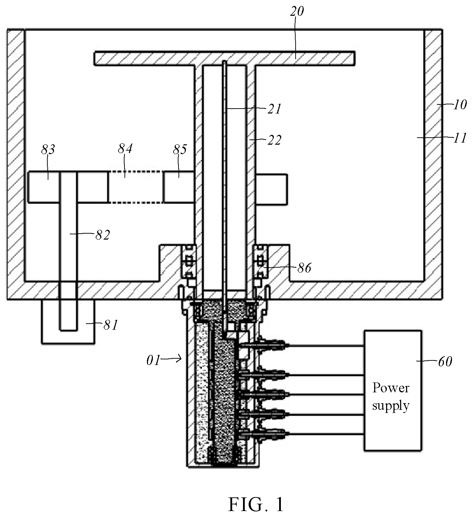

As shown in FIGs. 1 to 16, the present disclosure discloses a conductive slip ring 01. The disclosed conductive slip ring 01 is applied to a process chamber 10 of semiconductor process equipment. The disclosed conductive slip ring 01 includes a housing 30, a stationary electrical connection part 40, and a rotary electrical connection part 50.

The housing 30 is the outer shell of the conductive slip ring 01, and the housing 30 can provide a mounting base for other components of the conductive slip ring 01. Of course, the housing 30 can also provide peripheral protection for some components of the conductive slip ring 01. In addition, the housing 30 can serve as a mounting component for the conductive slip ring 01, enabling the conductive slip ring 01 to be mounted on the process chamber 10.

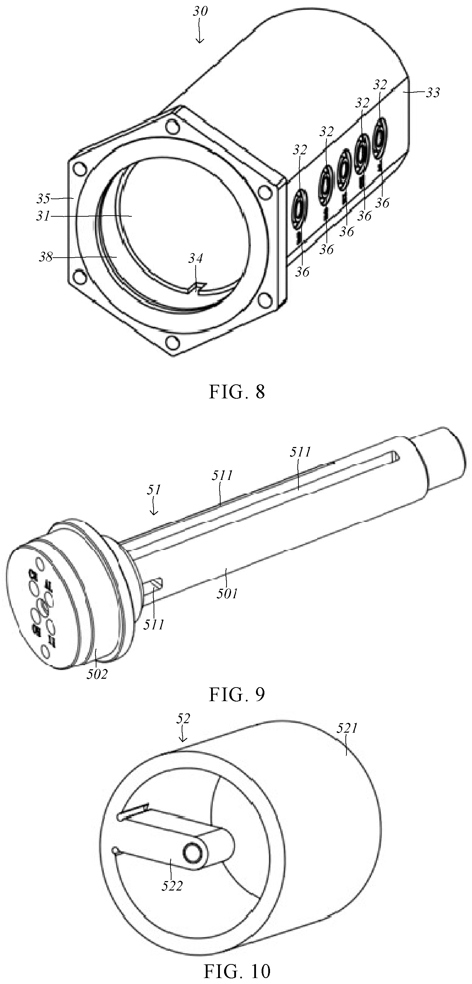

As shown in FIG. 8, the housing 30 includes a housing cavity 31 and a first mounting hole 32. The first mounting hole 32 communicates with the housing cavity 31 and is used to mount the stationary electrical connection part 40. Specifically, the housing 30 also includes a mating interface 38 that communicates with the housing cavity 31. The housing 30 is configured to be sealingly connected to the process chamber 10, so that the housing cavity 31 is in sealed connection with the chamber space 11 of the process chamber 10. Specifically, the mating interface 38 of the housing 30 is sealed and mated with the mating interface of the process chamber 10, thereby enabling connection between the housing cavity 31 and the chamber space 11 of the process chamber 10. It should be noted that the process chamber 10 includes a process space. The process space can be a part or the entirety of the chamber space 11, and the present disclosure does not impose any limitations.

The stationary electrical connection part 40 is an electrical connection part fixed in the conductive slip ring 01. The stationary electrical connection part 40 is fixed to the first mounting hole 32, thereby achieving a fixed connection with the housing 30. The stationary electrical connection part 40 is sealed and engaged with the first mounting hole 32. A first end of the stationary electrical connection part 40 extends into the housing cavity 31 and is electrically connected to the rotary electrical connection part 50. A second end of the stationary electrical connection part 40 is located outside the housing 30. The second end of the stationary electrical connection part 40 is configured to be electrically connected with the power supply 60. It should be noted that the power supply 60 is located outside the process chamber 10 and also outside the housing 30. The first end and the second end of the stationary electrical connection part 40 are opposite ends of the stationary electrical connection part 40.

The rotary electrical connection part 50 is movably disposed. The rotary electrical connection part 50 is rotatably disposed within the housing 30, i.e., within the housing cavity 31, thereby allowing the rotary electrical connection part to rotate relative to the stationary electrical connection part 40 and the housing 30. As described above, the first end of the stationary electrical connection part 40 is electrically connected to the rotary electrical connection part 50. Since the rotary electrical connection part 50 can rotate relative to the stationary electrical connection part 40, the first end of the stationary electrical connection part 40 and the rotary electrical connection part 50 are electrically connected through contact and in sliding electrical contact.

Consistent with the present disclosure, the rotary electrical connection part 50 is configured to be electrically connected with an electrical device 21 within the process chamber 10. The electrical device 21 is a device that needs to rotate within the process chamber 10 and requires electrical power. For example, a carrier 20 is rotatably mounted within the chamber space 11 of the process chamber 10. An electrical device 21 is embedded within the carrier 20 and can rotate with the carrier 20. The electrical device 21 can be a heating device, an electrostatic adsorption electrode, etc. The present disclosure imposes no limitation on the specific type and structure of the electrical device 21.

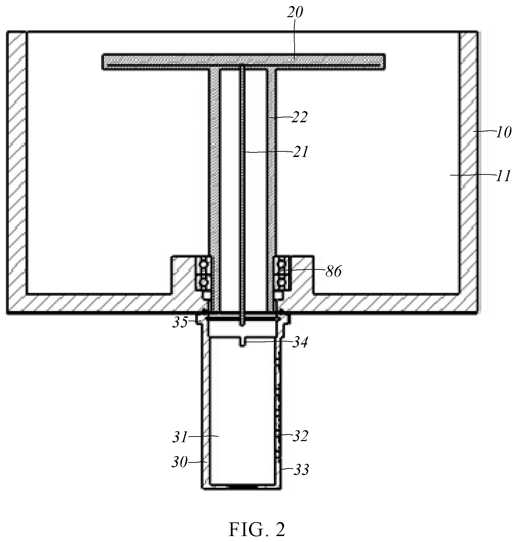

After the conductive slip ring 01 of the present disclosure is installed in the process chamber 10, the housing cavity 31 can be sealed and connected to the chamber space 11 of the process chamber 10, as shown in FIGs. 1 and 2. The stationary electrical connection part 40 is installed in the first mounting hole 32 and seals with the first mounting hole 32. In this case, the overall space formed after the housing cavity 31 and the chamber space 11 are connected is sealed and isolated from the external environment (i.e., the environment outside the process chamber 10 and the housing 30) due to the sealing engagement between the stationary electrical connection part 40 and the first mounting hole 32. Simultaneously, the electrical energy provided by the power supply 60 is transmitted from the second end of the stationary electrical connection part 40 to the first end of the stationary electrical connection part 40, then conducted from the first end of the stationary electrical connection part 40 to the rotary electrical connection part 50, and finally transmitted from the rotary electrical connection part 50 to the electrical device 21 within the process chamber 10. As such, by establishing an electrical connection that allows the stationary electrical connection part 40 and the rotary electrical connection part 50 to rotate relative to each other, the stationary electrical connection part 40 and the rotary electrical connection part 50 can maintain contact electrical connection while the rotary electrical connection part 50 rotates with the electrical device 21, thereby achieving rotary power supply.

Through the above power supply process, the conductive slip ring 01 of the present disclosure can achieve rotary power supply while simultaneously achieving a sealed engagement between the stationary electrical connection part 40 and the first mounting hole 32. This allows the overall space formed after the housing cavity 31 and the chamber space 11 are connected to form a sealed isolation from the external environment where the power supply 60 is located, ultimately maintaining a vacuum environment within the chamber space 11. This rotary power supply technology eliminates the need of magnetohydrodynamic structures for sealing, thus avoiding the influence of external magnetic fields on the sealing performance and overcoming the problem of poor sealing performance caused by external magnetic field interference in magnetohydrodynamic sealing.

Consistent with the present disclosure, the stationary electrical connection part 40 is sealed to the first mounting hole 32 to isolate the external environment. Various methods can be used to achieve a seal between the stationary electrical connection part 40 and the first mounting hole 32; for example, sealant can be filled between the stationary electrical connection part 40 and the hole wall of the first mounting hole 32.

Of course, the structure of the stationary electrical connection part 40 can vary. The stationary electrical connection part 40 may include a conventional metal wire passing through the first mounting hole 32 and filled with sealant between the metal wire and the hole wall of the first mounting hole 32. The present disclosure does not limit the specific structure of the stationary electrical connection part 40.

In some embodiments, the stationary electrical connection part 40 in the present disclosure may include a brush 41. The brush 41 can slide against the outer peripheral wall of the rotary electrical connection part 50 in the rotation direction of the rotary electrical connection part 50, thereby achieving a contact electrical connection between the stationary electrical connection part 40 and the rotary electrical connection part 50. Of course, the sliding contact electrical connection structure between the stationary electrical connection part 40 and the rotary electrical connection part 50 can be brush-shaped or non-brush-shaped; the present disclosure does not impose any limitations.

The stationary electrical connection part 40 of the present disclosure may also include a power connector 42. The first end of the power connector 42 extends into the housing cavity 31 and is electrically connected to the brush 41, achieving a sliding engagement with the rotary electrical connection part 50 through the brush 41. Of course, after the first end of the power connector 42 extends into the housing cavity 31, the first end of the power connector 42 may also slide directly against the rotary electrical connection part 50 without passing through the brush 41, thereby achieving a contact electrical connection. In this case, the stationary electrical connection part 40 may not include the brush 41.

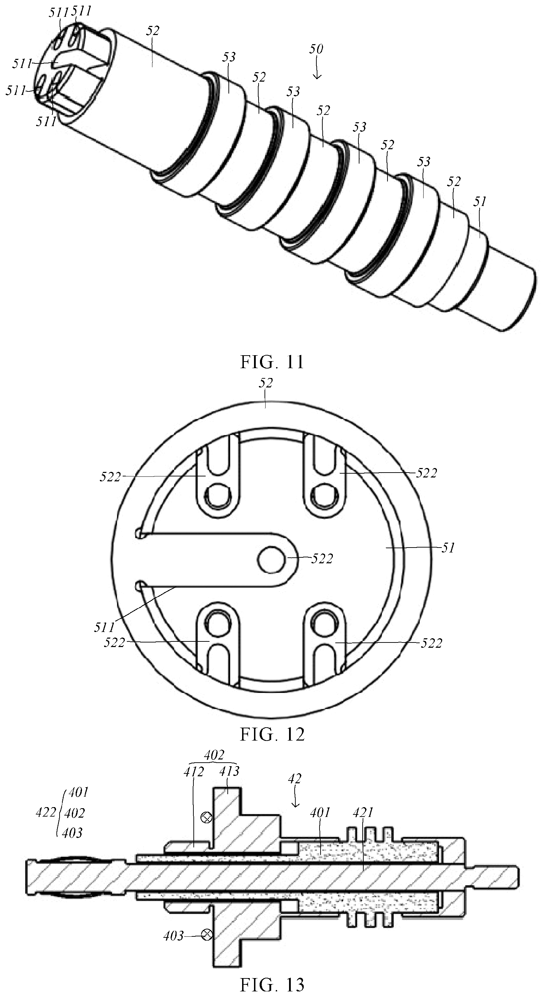

Consistent with the present disclosure, the power connector 42 can be a common metal wire as described above, or other structures. As shown in FIG. 13, in some embodiments, the power connector 42 may include an electrical conductor 421 and a sealing part 422. The electrical conductor 421 passes through the first mounting hole 32, and the end of the electrical conductor 421 located inside the housing 30 is the first end of the power connector 42, meaning that the end of the electrical conductor 421 located inside the housing 30 can directly or indirectly achieve sliding electrical contact with the rotary electrical connection part 50 through the brush 41. The end of the electrical conductor 421 located outside the housing 30 can be the second end of the power connector 42, configured to be electrically connected with the power supply 60. The sealing part 422 covers a part of the electrical conductor 421 and is at least sealed between the hole wall of the first mounting hole 32 and the electrical conductor 421. The sealing part 422 can be a sealing sleeve engaged onto the electrical conductor 421 or a sealant applied to the electrical conductor 421. The embodiments of the present disclosure do not limit the specific structure of the sealing part 422. The sealing part 422 is sealed to both the surface of the electrical conductor 421 and the wall of the first mounting hole 32, thereby achieving a sealed engagement between the power connector 42 and the first mounting hole 32. In this case, the sealing part 422 not only performs a sealing function, but also at least fills the space between the electrical conductor 421 and the wall of the first mounting hole 32, thereby achieving a fixed connection between the power connector 42 and the first mounting hole 32. Meanwhile, consistent with the present disclosure, the electrical conductor 421 is specifically used for transmitting electrical energy, and the length of the electrical conductor 421 can be flexibly adjusted to adapt to the position of the rotary electrical connection part 50.

As described above, the embodiments of the present disclosure do not limit the specific structure of the sealing part 422. As shown in FIG. 13, the present disclosure discloses a sealing part 422 with a specific structure. The disclosed sealing part 422 includes an insulation part 401, a compression part 402, and a first sealing ring 403. The compression part 402 includes an external threaded connection sleeve 412 and a compression body 413 that are fixedly connected to each other. The insulation part 401 is sealed onto the electrical conductor 421, thereby achieving a seal between the insulation part 401 and the electrical conductor 421. The insulation part 401 can include insulating adhesive.

The compression part 402 is sealed onto the insulation part 401. That is, both the external threaded connection sleeve 412 and the compressing body 413 are sealed onto the insulation part 401, thereby achieving a seal between the compression part 402 and the insulation part 401. The external threaded connection sleeve 412 is fixedly connected to the first mounting hole by threads 32, thus achieving a detachable connection. The compressing body 413 compresses the first sealing ring 403 surrounding the outer port of the first mounting hole 32 against the outer wall surface of the housing 30. In this case, the first sealing ring 403 can achieve a seal between the compressing body 413 and the outer wall surface of the housing 30, thereby indirectly achieving a seal of the thread clearance between the external threaded connection sleeve 412 and the first mounting hole 32.

Consistent with the present disclosure, the external threaded connection sleeve 412 is fixedly connected to the first mounting hole 32 via threads, facilitating a detachable connection between the power connector 42 and the first mounting hole 32, thereby enabling quick assembly and disassembly of the power connector 42. Consistent with the present disclosure, the compression of the first sealing ring 403 by the compression body 413 can originate from the threaded engagement between the external threaded connection sleeve 412 and the first mounting hole 32. That is, after the external threaded connection sleeve 412 is threadedly connected to the first mounting hole 32, since the external threaded connection sleeve 412 is connected to the compression body 413, the external threaded connection sleeve 412 can pull the compression body 413, causing the compression body 413 to tend to compress against the outer wall surface of the housing 30. In this case, the compression body 413 can compress the first sealing ring 403 against the outer wall surface of the housing 30, thereby achieving a seal between the compression body 413 and the outer wall surface of the housing 30.

To better compress the first sealing ring 403, the compression body 413 can be a sheetlike structure, thus facilitating comprehensive compression of the first sealing ring 403.

To improve connection stability, in a further technical solution, the compression body 413 can be detachably connected to the housing 30 via a threaded connector (e.g., screw, bolt), thereby avoiding the problem of reduced compression effect on the first sealing ring 403 due to loosening of the external threaded connection sleeve 412.

Consistent with the present disclosure, the outer wall surface of the housing 30 can have a first plane 33, and the first sealing ring 403 can be compressed between the first plane 33 and the compression body 413. In this case, the first plane 33 provides a relatively flat compression surface, facilitating more even compression of various areas of the first sealing ring 403, thus ensuring a better sealing performance.

In other or further embodiments, at least one of the outer wall surface of the housing 30 or the surface of the compression body 413 facing the housing 30 may be provided with a mounting groove 36. The first sealing ring 403 can be positioned and installed in the mounting groove 36. In this case, the first sealing ring 403 is restricted by the positioning of the mounting groove 36, thereby improving the installation stability of the first sealing ring 403. In addition, the engagement between the first sealing ring 403 and the mounting groove 36 makes it easier to form a labyrinth seal structure, thereby further improving the sealing performance.

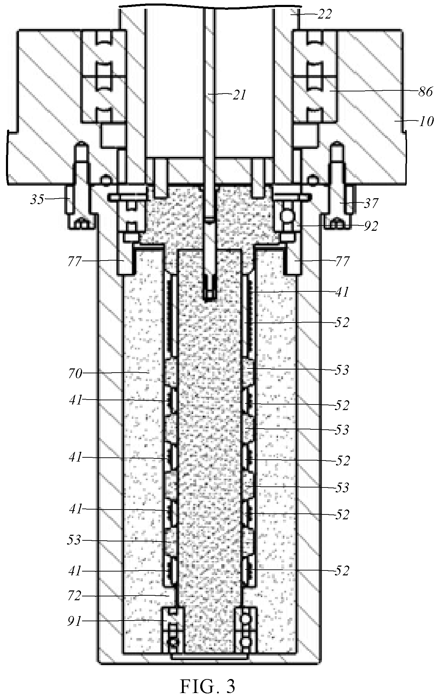

As shown in FIGs. 3 to 7, consistent with the present disclosure, the conductive slip ring 01 may further include a stationary insulating sleeve 70. The stationary insulating sleeve 70 is disposed inside the housing 30, i.e., in the housing cavity 31, and is sleeved outside the rotary electrical connection part 50. The rotary electrical connection part 50 is at least partially rotatably disposed within the stationary insulating sleeve 70, and is at least insulated from the housing 30 by the stationary insulating sleeve 70, thereby preventing the rotary electrical connection part 50 from making electrical contact with the housing 30. The stationary electrical connection part 40 passes through the stationary insulating sleeve 70 and is rotatably connected to the rotary electrical connection part 50. Of course, to avoid static electricity on the housing 30, the housing 30 is grounded; or, the housing 30 is connected to a grounded peripheral component of the process chamber 10, and the housing 30 is also grounded. In this case, the insulation of the stationary insulating sleeve 70 prevents the rotary electrical connection part 50 from grounding.

As described above, the stationary electrical connection part 40 may include a power connector 42, the first end of the power connector 42 can achieve sliding electrical contact with the rotary electrical connection part 50 via the brush 41. The brush 41 can achieve electrical connection with the power supply 60 via the power connector 42, with the power connector 42 sealed and engaged with the first mounting hole 32 as described above. Of course, the connection with the power supply 60 is not limited to the power connector 42. The present disclosure does not exclude the possibility that the brush 41, after sealing and engaging with the first mounting hole 32, extends partially outside the housing 30 and is directly electrically connected to the power supply 60.

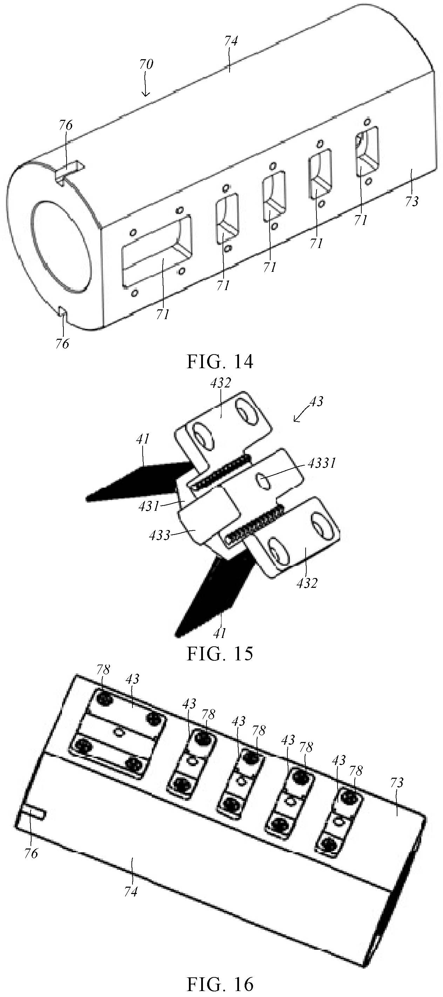

In the case where the stationary electrical connection part 40 includes the brush 41, in a further technical solution, as shown in FIG. 14, the stationary insulating sleeve 70 may be provided with a second mounting hole 71. The brush 41 is installed in the second mounting hole 71, and is at least partially located within the stationary insulating sleeve 70. In this case, the stationary insulating sleeve 70 not only plays a role in insulation and isolation, but also provides an insulating mounting base for the brush 41, thereby enabling the brush 41 to be installed within the housing 30.

The brush 41 has good elasticity or flexibility, and a low strength of the brush 41 facilitates the generation of a certain elastic force with the rotary electrical connection part 50, achieving stable electrical contact. To facilitate the fixation and installation of the brush 41, the stationary electrical connection part 40 may also include a mounting bracket 43 installed in the second mounting hole 71, and the brush 41 is connected to the mounting bracket 43. The first end of the power connector 42, located within the housing cavity 31, is electrically connected to the mounting bracket 43, and the mounting bracket 43 electrically connects the brush 41 and the power connector 42. The power connector 42 is sealed to the first mounting hole 32, and the second end of the power connector 42, located outside the housing 30, is configured to be electrically connected to the power supply 60. In this case, the mounting bracket 43 enables relatively stable mounting of the brush 41 on the stationary insulating sleeve 70.

Consistent with the present disclosure, the mounting bracket 43 can have various structures, as long as the mounting bracket 43 enables the mounting of the brush 41 and the electrical connection between the brush 41 and the power connector 42. The present disclosure does not limit the specific structure of the mounting bracket 43. As shown in FIGs. 15 and 16, in some embodiments, the mounting bracket 43 may include a groove-shaped body 431, two connection fins 432, and an electrical connection protrusion 433. The two connection fins 432 are respectively connected to the top ends of the two side walls of the groove-shaped body 431 (i.e., the side walls at the end where the groove opening is located), and extend from the groove opening of the groove-shaped body 431 towards opposite sides. The electrical connection protrusion 433 is at least partially located within the groove-shaped body 431 and is electrically connected to the first end of the power connector 42. Both connection fins 432 are fixedly connected to the stationary insulating sleeve 70. Each mounting bracket 43 can connect at least one brush 41, such as the two brushes 41 shown in FIG. 15. One end of each brush 41 is fixed in a third mounting hole penetrating the bottom of the groove-shaped body 431 and located on both sides of the electrical connection protrusion 433. The other ends of the two brushes 41 extend in a direction away from the groove opening of the groove-shaped body 431. Of course, each mounting bracket 43 can also connect one or more brushes 41; the embodiments of the present disclosure do not limit the number of brushes 41 connected to each mounting bracket 43.

Consistent with the present disclosure, the two connection fins 432 can extend on opposite sides of the groove opening of the groove-shaped body 431, thereby achieving a relatively stable connection with the stationary insulating sleeve 70. Furthermore, the mounting bracket 43 uses the groove-shaped main body 431 as main structure. The groove-shaped main body 431 and the two connection fins 432 can form an arc-like structure, giving the mounting bracket 43 good elasticity, and facilitating elastic contact between the brush 41 and the rotary electrical connection part 50, better avoiding rigid contact and thus preventing adverse effects on the brush 41 when the rotary electrical connection part 50 rotates. Meanwhile, the electrical connection protrusion 433 is a component located within the groove-shaped main body 431, specifically designed for connection with the power connector 42, facilitating electrical connection with the power connector 42.

As shown in FIG. 15, in some embodiments, the electrical connection protrusion 433 may have an electrical connection hole 4331. The end of the electrical conductor 421 located within the housing 30 can be directly connected to the electrical connection hole 4331. Specifically, the end of the electrical conductor 421 located within the housing 30 can be a threaded end, and the electrical connection hole 4331 can be a threaded hole. The threaded end can be directly screwed into the threaded hole to achieve a stationary electrical connection part. Of course, the electrical connection between the electrical connection protrusion 433 and the end of the electrical conductor 421 located inside the housing 30 can also be electrically connected by welding, conductive adhesive bonding, etc., and the present disclosure does not impose any limitations.

In the present disclosure, the outer wall surface of the stationary insulating sleeve 70 may include a second plane 73, and both the two connection fins 432 are fixedly connected to the second plane 73. In this case, the two connection fins 432 can engage against the second plane 73, thereby improving the stability of the connection between the two connection fins 432 and the stationary insulating sleeve 70. In some embodiments, the connection fins 432 and the second plane 73 can be fixedly connected by a first threaded connector 78.

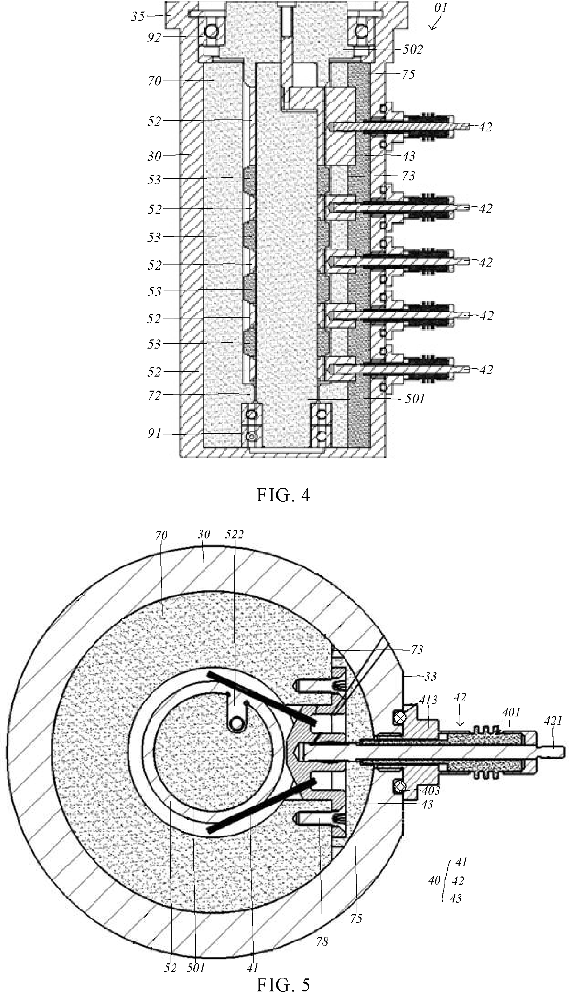

The stationary insulating sleeve 70 can have various shapes, such as a square sleeve, a circular sleeve, etc., and the present disclosure does not impose any limitations. As shown in FIG. 16, in some embodiments, the outer wall surface of the stationary insulating sleeve 70 may further include a first curved surface 74. Each part of the first curved surface 74 is located within a first cylindrical surface, and the first curved surface 74 is connected end-to-end with the second plane 73. The inner wall surface of the housing 30 is a second cylindrical surface concentrically distributed with the first cylindrical surface. The gap between the areas where the second plane 73 and the second cylindrical surface are opposite each other may be provided with an insulating sealing filling part 75, as shown in FIG. 5. In this case, the stationary insulating sleeve 70 can be as similar in shape to the housing 30 as possible, avoiding excessive space occupation and minimizing the generation of large gaps. Simultaneously, the gap design facilitates the accommodation of part of the mounting bracket 43, while the insulating sealing filling part 75 allows the larger gap between the areas where the second plane 73 and the second cylindrical surface are opposite each other to be filled, ensuring greater stability of the components installed inside the housing 30.

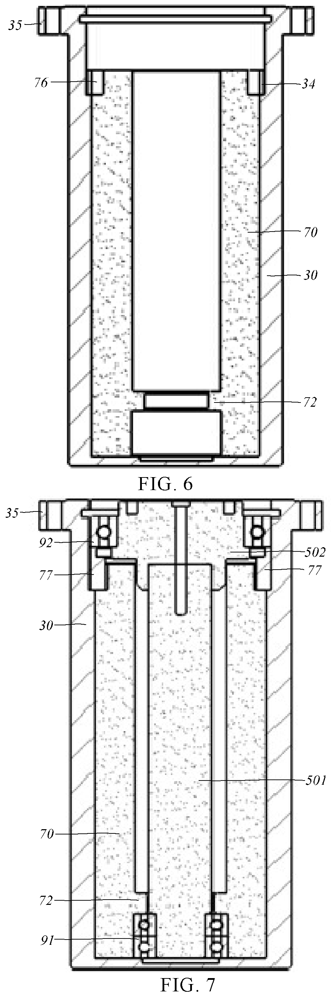

Consistent with the present disclosure, the stationary insulating sleeve 70 is fixed inside the housing 30. Specifically, there are various ways to fix the stationary insulating sleeve 70 inside the housing 30, and the present disclosure does not limit this. In some embodiments, the end of the stationary insulating sleeve 70 adjacent to the process chamber 10 may be provided with a plurality of first positioning grooves 76, as shown in FIG. 14. The openings of the plurality of first positioning grooves 76 face the inner wall of the housing 30 and extend to the end face of the stationary insulating sleeve 70. The inner wall of the housing 30 may be provided with a plurality of second positioning grooves 34 (as shown in FIG. 8). The openings of the plurality of second positioning grooves 34 mate one-to-one with the openings of the plurality of first positioning grooves 76 to form a positioning space. The stationary insulating sleeve 70 can be connected to the housing 30 by a positioning member 77 installed in the positioning space. Specifically, the positioning member 77 can be a connection key. This connection method includes a simple structure and can achieve disassembly between the stationary insulating sleeve 70 and the housing 30 by removing the positioning member 77, and achieve connection between the stationary insulating sleeve 70 and the housing 30 by installing the positioning member 77, thereby enabling disassembly and assembly, as shown in FIG. 7.

The rotary electrical connection part 50 can have various structures, and the present disclosure does not limit on this. As shown in FIGs. 9, 10, 11, and 12, in some embodiments, the rotary electrical connection part 50 includes an insulating shaft 51 and a conductive ring 52 sleeved on the insulating shaft 51. Both the insulating shaft 51 and the conductive ring 52 are disposed within the stationary insulating sleeve 70, and the conductive ring 52 can rotate with the insulating shaft 51. The conductive ring 52 is electrically connected to the first end of the stationary electrical connection part 40 located within the housing cavity 31. The insulating shaft 51 is rotatably mounted within the housing 30. The conductive ring 52 is configured to be electrically connected with the electrical device 21. Consistent with the present disclosure, the conductive ring 52 is electrically connected to the stationary electrical connection part 40, thereby forming a corresponding electrical connection relationship. This facilitates the realization of multiple sets of corresponding electrical connections between the conductive ring 52 and the stationary electrical connection part 40, thus enabling the planning of more electrical connection paths within a smaller space. Furthermore, the rotary electrical connection part 50 of this structure is rotatably mounted based on the insulating shaft 51, and an electrical connection is achieved through the conductive ring 52 mounted on the insulating shaft 51. This allows the insulating shaft 51 to form an isolation between the conductive ring 52 and other components that do not need electrical connection to the conductive ring 52, preventing short circuits.

As shown in FIG. 10, in a further technical solution, the conductive ring 52 may include an annular body 521 and an electrical terminal 522 disposed within the annular body 521. The first end of the electrical terminal 522 is electrically connected to the inner annular surface of the annular body 521. As shown in FIG. 9, the insulating shaft 51 includes an electrical terminal clearance groove 511 extending axially therein. The second end of the electrical terminal 522 extends into the electrical terminal clearance groove 511 (as shown in FIG. 12) and is configured to be electrically connected with the electrical device 21. The outer annular surface of the annular body 521 is electrically contacted with the stationary electrical connection part 40. During the rotation of the rotary electrical connection part 50, the outer annular surface of the annular body 521 makes sliding contact with the stationary electrical connection part 40, thereby achieving rotary power supply. This structure of the conductive ring 52 allows the electrical terminal 522 to perform electrical connection function with the electrical device 21 while also being housed within the insulating shaft 51. Insulating shaft 51 sacrifices partial structure of the insulating shaft 51 to form an electrical terminal clearance groove 511, thereby accommodating the electrical terminal 522, facilitating the miniaturization design of the rotary electrical connection part 50.

Of course, the conductive ring 52 can also achieve electrical connection with the electrical device 21 through a conductive layer (e.g., conductive plating, conductive coating, etc.) provided on the outer wall of the insulating shaft 51 and extending axially along the insulating shaft 51.

As described above, the electrical terminal 522 extends into the electrical terminal clearance groove 511. Specifically, the electrical terminal 522 may only extend into the electrical terminal clearance groove 511 without contacting or rigidly engaging with the inner wall of the electrical terminal clearance groove 511. Of course, the electrical terminal 522 may extend into the electrical terminal clearance groove 511 and simultaneously contact the inner wall of the electrical terminal clearance groove 511, thereby forming a more stable engagement. As such, in some embodiments, the first end of the electrical terminal 522 is fixedly connected to the annular body 521. The annular body 521 engages with the electrical terminal clearance groove 511 via the second end of the electrical terminal 522, and the annular body 521 and the insulating shaft 51 are in a limiting engagement in the rotational direction of the rotary electrical connection part 50. In this case, the electrical terminal 522 not only provides electrical connection but also, through the engagement between the electrical terminal 522 with the electrical terminal clearance groove 511, allows the annular body 521 and the insulating shaft 51 are in a limiting engagement in the rotational direction of the insulating shaft 51 (i.e., the rotational direction of the rotary electrical connection part 50), thus preventing relative rotation of the annular body 521 relative to the insulating shaft 51. This undoubtedly improves the stability of the connection between the annular body 521 and the insulating shaft 51.

Normally, the electrical devices 21 within the process chamber 10 can be one or more (i.e., at least two). When there are multiple electrical devices 21, there are multiple conductive rings 52, spaced apart axially along the insulating shaft 51. The insulating shaft 51 has multiple spaced-apart electrical terminal clearance grooves 511, and the second end of the electrical terminal 522 of each conductive ring 52 extends into the corresponding electrical terminal clearance groove 511. In this case, each conductive ring 52 can supply power to a corresponding electrical device 21. Simultaneously, in this case, there can also be multiple stationary electrical connection parts 40, each corresponding to a conductive ring 52, thereby achieving the purpose of supplying power to multiple electrical devices 21. This independent power supply mode makes it easier to adjust according to the power needs of multiple electrical devices 21, thus easily meeting the diverse power needs of multiple electrical devices 21.

In one specific embodiment, there may be multiple conductive rings 52, spaced apart along the axial direction of the insulating shaft 51. There may also be multiple stationary electrical connection parts 40, spaced apart along the axial direction of the insulating shaft 51. Each conductive ring 52 is electrically connected to a corresponding stationary electrical connection part 40 and a corresponding electrical device 21.

When the stationary electrical connection part 40 includes brushes 41 and power connectors 42, there may be multiple sets of brushes 41, spaced apart along the axial direction of the insulating shaft 51. There may also be multiple power connectors 42, spaced apart along the axial direction of the insulating shaft 51. Each set of brushes 41 is electrically connected to a corresponding conductive ring 52 and a corresponding power connector 42.

Each stationary electrical connection part 40 may include a set of brushes 41. Consistent with the present disclosure, a set of brushes 41 engaging with each conductive ring 52 may include one brush 41 or multiple brushes 41. The present disclosure does not limit the number of brushes 41 included in a set of brushes 41. In some embodiments, each set of brushes 41 may include two brushes 41. The distance between the ends of the two brushes 41 in the same set that are away from the conductive ring 52 is smaller than the distance between the ends that are closer to the conductive ring 52. The two brushes 41 in the same set are tangential and abut against different parts of the conductive ring 52. In this case, each power connector 42 achieves sliding electrical contact with the conductive ring 52 through the two brushes 41, improving the stability of the electrical contact.

To align with the positions of the multiple conductive rings 52, the first ends of the multiple electrical terminal clearance grooves 511 are located on the end face of the insulating shaft 51 adjacent to the electrical device 21. The second ends of the multiple electrical terminal clearance grooves 511 extend to the corresponding positions of the corresponding electrical terminals 522. That is, the second ends of the multiple electrical terminal clearance grooves 511 extend to the positions of the corresponding conductive rings 52. The multiple electrical terminal clearance grooves 511 are at least not all through grooves. In this configuration, the second ends of the multiple electrical terminal clearance grooves 511 extend to the positions of the corresponding conductive rings 52, allowing the electrical terminals 522 of the corresponding conductive rings 52 to extend into for assembling. Simultaneously, the multiple electrical terminal clearance grooves 511 do not need to extend to both ends of the entire insulating shaft 51, thus minimizing impact on the strength of the insulating shaft 51.

As mentioned above, the electrical needs of the multiple electrical devices 21 differ, necessitating different sizes for the conductive rings 52. Based on this, in some embodiments, the lengths of the annular bodies 521 of the multiple conductive rings 52 along the axial direction of the insulating shaft 51 are not all equal; that is, at least two of the annular bodies 521 of the multiple conductive rings 52 are not equal along the axial direction of the insulating shaft 51. For example, among the multiple conductive rings 52, the longest conductive ring 52 can be used to input radio frequency current, while the second longest conductive ring 52 can be used to supply alternating current to the electrical device 21 as a heating device. The shortest conductive ring 52 can be used to supply direct current to a thermocouple or electrostatic adsorption electrode.

When there are multiple conductive rings 52, the multiple conductive rings 52 can be spaced apart along the axial direction of the insulating shaft 51. The conductive rings 52 are fixed to the insulating shaft 51 through a tight engagement between the annular body 521 and the insulating shaft 51. Of course, the conductive rings 52 can be fixedly connected to the insulating shaft 51 through an engagement between the electrical terminal 522 and the electrical terminal clearance groove 511; in this case, the electrical terminal 522 and the electrical terminal clearance groove 511 are tightly engaged. Multiple conductive rings 52 are fixed to the insulating shaft 51 and are spaced apart to avoid contact with each other, thereby preventing short circuits between adjacent conductive rings 52.

In other embodiments, the rotary electrical connection part 50 may also include an insulating isolator 53, with an insulating isolator 53 provided between each adjacent conductive ring 52. In this case, the insulation of the insulating isolator 53 prevents adjacent conductive rings 52 from moving and contacting each other, and also effectively avoids short circuits.

Consistent with the present disclosure, the insulating shaft 51 is rotatably disposed within the housing 30. The insulating shaft 51 can be rotatably mounted using a simple shafthole fit. However, to mitigate wear and improve rotational stability, as shown in FIG. 3, the insulating shaft 51 can be rotatably disposed within the stationary insulating sleeve 70 via a first bearing 91. The stationary insulating sleeve 70 may be provided with an annular isolation protrusion 72 fixed relative to the stationary insulating sleeve 70. The first bearing 91 is located on a first side of the annular isolation protrusion 72. The conductive ring 52 can be located on a second side of the annular isolation protrusion 72, with the first side opposite the second side. In this case, the annular isolation protrusion 72 isolates the first bearing 91 and the conductive ring 52, thereby preventing particles generated by the first bearing 91 after long-term operation from entering the space where the conductive ring 52 is located, thus avoiding adverse effects on the sliding electrical contact of the conductive ring 52.

In some embodiments, the first end of the insulating shaft 51 is rotatably disposed within the housing 30 via a first bearing 91, and the second end of the insulating shaft 51 is rotatably disposed within the housing 30 via a second bearing 92. Specifically, the annular isolation protrusion 72 may be disposed only between the first bearing 91 and the conductive ring 52, as shown in FIG. 7.

Consistent with the present disclosure, the insulating shaft 51 may be an integral structure or a split structure. As shown in FIG. 9, in some embodiments, the insulating shaft 51 is a split structure, and the insulating shaft 51 may include a first shaft segment 501 and a second shaft segment 502. The first shaft segment 501 and the second shaft segment 502 are detachably connected. The aforementioned electrical terminal clearance groove 511 may be formed on the first shaft segment 501, and the second shaft segment 502 may have a clearance hole opposite to the corresponding electrical terminal clearance groove 511, so as not to affect the electrical connection between the electrical device 21 and the corresponding electrical terminal 522.

Based on the conductive slip ring 01 disclosed in the embodiments of the present disclosure, the present disclosure discloses semiconductor process equipment. The semiconductor process equipment includes a process chamber 10, a carrier 20, and the conductive slip ring 01 described above.

The carrier 20 is used to carry the wafer and drive the wafer to rotate during the process to improve the uniformity of film deposition on the wafer. The carrier 20 includes an electrical device 21. The electrical device 21 may be an electrostatic adsorption electrode, heating coil, etc., disposed inside the carrier 20.

The carrier 20 is disposed within the process chamber 10. The carrier 20 is rotatably disposed within the process chamber 10, and the electrical device 21 is disposed within the carrier 20. The housing 30 is sealed to the process chamber 10, and the housing cavity 31 communicates with the chamber space 11 of the process chamber 10. A rotary electrical connection part 50 is connected to the carrier 20 and electrically connected to the electrical device 21 within the carrier 20. The rotary electrical connection part 50 and the carrier 20 can rotate synchronously, thereby realizing rotary power supply.

Consistent with the present disclosure, the housing 30 of the conductive slip ring 01 includes a connection flange 35 surrounding the mating interface 38 of the housing 30. The connection flange 35 is detachably connected to the process chamber 10 via a second threaded connector 37.

The semiconductor process equipment disclosed in the present disclosure may further include a drive mechanism. The drive mechanism may include a drive motor 81, a rotating shaft 82, a driving wheel 83, a conveyor belt 84, and a driven wheel 85. The drive motor 81 is fixed outside the process chamber 10. One end of the rotating shaft 82 is connected to the drive motor 81, and the other end of the rotating shaft 82 extends into the process chamber 10. The driving wheel 83 is fixed on the part of the rotating shaft 82 located inside the process chamber 10. The conveyor belt 84 connects the driving wheel 83 and the driven wheel 85. The driven wheel 85 is connected to a support shaft 22 supporting the carrier 20, so that the driven wheel 85 can drive the support shaft 22 to rotate during rotation, ultimately realizing the rotation of the entire carrier 20. Of course, the electrical devices 21 inside the carrier 20 will also rotate synchronously. Specifically, the support shaft 22 can be rotatably mounted at the interface of the process chamber 10 via the third bearing 86.

It should be noted that the structure of the drive mechanism can be varied and is not limited to the structure described above. The present disclosure does not impose any limitations.

The above embodiments of the present disclosure focus on describing the differences between various embodiments. Different optimized features of various embodiments, as long as there is no contradiction, can be combined to form better embodiments. For the sake of brevity, these will not be elaborated further here.

The embodiments of the present disclosure have been described above with reference to the accompanying drawings. However, the present disclosure is not limited to the specific embodiments described above. The specific embodiments described above are merely illustrative and not restrictive. Those skilled in the art, under the guidance of the present disclosure, can make many modifications without departing from the spirit and scope of the claims, all of which fall within the scope of the present disclosure.

## Claims

1. A conductive slip ring applied to a process chamber of semiconductor process equipment, the conductive slip ring comprising a housing, a stationary electrical connection part, and a rotary electrical connection part, wherein:
the housing includes a housing cavity and a first mounting hole communicating with the housing cavity, the housing being configured to be sealingly connected to the process chamber, so that the housing cavity is in sealed connection with a chamber space of the process chamber;
the stationary electrical connection part is in sealing engagement with the first mounting hole, and a first end of the stationary electrical connection part extends into the housing cavity and is rotatably electrically connected to the rotary electrical connection part, a second end of the stationary electrical connection part is located outside the housing and configured to be electrically connected to a power supply;
the rotary electrical connection part is rotatably disposed within the housing and configured to be electrically connected to an electrical device within the process chamber.

2. The conductive slip ring according to claim 1, wherein, the stationary electrical connection part includes a power connector, the power connector includes an electrical conductor and a sealing part, the electrical conductor passes through the first mounting hole, an end of the electrical conductor located inside the housing makes slidable electrical contact with the rotary electrical connection part, an end of the electrical conductor located outside the housing is configured to be electrically connected with the power supply, and the sealing part encloses a part of the electrical conductor and is at least sealed between a wall of the first mounting hole and the electrical conductor.

3. The conductive slip ring according to claim 2, wherein, the sealing part includes an insulation part, a compressing part, and a first sealing ring, the compressing part includes an external threaded connection sleeve and a compression body fixedly connected to each other, the insulation part is sealingly sleeved on the electrical conductor, the external threaded connection sleeve and the compression body are both sealingly sleeved on the insulation part, the external threaded connection sleeve is fixedly connected to the first mounting hole by threads, and the compression body compresses the first sealing ring surrounding an outer port of the first mounting hole onto an outer wall surface of the housing.

4. The conductive slip ring according to claim 3, wherein, the outer wall surface of the housing includes a first plane, and the first sealing ring is compressed between the first plane and the compression body; or,
at least one of the outer wall surface of the housing and a surface of the compression body facing the housing is provided with a mounting groove, and the first sealing ring is positioned and installed in the mounting groove.

5. The conductive slip ring according to claim 1, wherein, the conductive slip ring further includes a stationary insulating sleeve, the stationary insulating sleeve being disposed inside the housing and sleeved outside the rotary electrical connection part, the rotary electrical connection part being at least partially rotatably disposed inside the stationary insulating sleeve and insulated from the housing at least through the stationary insulating sleeve, the stationary electrical connection part passing through the stationary insulating sleeve and being rotatably electrically connected to the rotary electrical connection part.

6. The conductive slip ring according to claim 5, wherein, the stationary electrical connection part includes a brush, the brush slidingly engaging with an outer peripheral wall of the rotary electrical connection part in a rotational direction of the rotary electrical connection part, the stationary insulating sleeve including a second mounting hole, the brush being mounted in the second mounting hole and at least partially located within the stationary insulating sleeve.

7. The conductive slip ring according to claim 6, wherein, the stationary electrical connection part further includes a mounting bracket and a power connector, the mounting bracket being mounted in the second mounting hole, the brush being connected to the mounting bracket, a first end of the power connector located within the housing cavity being electrically connected to the mounting bracket, the mounting bracket electrically connecting the brush and the power connector, the power connector sealingly engaging with the first mounting hole, and a second end of the power connector located outside the housing being configured to be electrically connected with the power supply.

8. The conductive slip ring according to claim 7, wherein, the mounting bracket includes a groove-shaped body, two connection fins, and an electrical connection protrusion, the two connection fins being respectively connected to top ends of two side walls of the groove-shaped body, and respectively extending from a groove opening of the groove-shaped body towards two opposite sides, the electrical connection protrusion being at least partially located within the groove-shaped body, and being electrically connected to the first end of the power connector, the two connection fins being both fixedly connected to the stationary insulating sleeve, a mounting bracket connecting to at least one brush, one end of the at least one brush being fixed in a third mounting hole penetrating a bottom of the groove-shaped body, and an other end of the at least one brush extending in a direction away from the groove opening of the groove-shaped body.

9. The conductive slip ring according to claim 8, wherein, an outer wall surface of the stationary insulating sleeve includes a second plane, and the two connection fins are both fixedly connected to the second plane.

10. The conductive slip ring according to claim 5, wherein, a plurality of first positioning grooves are provided at an end of the stationary insulating sleeve adjacent to the process chamber, openings of the plurality of first positioning grooves facing an inner wall of the housing and extending to an end face of the stationary insulating sleeve, the inner wall of the housing is provided with a plurality of second positioning grooves, openings of the plurality of second positioning grooves aligning with the openings of the plurality of first positioning grooves to form a positioning space, the stationary insulating sleeve being connected to the housing through a positioning member installed in the positioning space.

11. The conductive slip ring according to claim 5, wherein, the rotary electrical connection part includes an insulating shaft disposed within the stationary insulating sleeve and a conductive ring sleeved on the insulating shaft and rotating with the insulating shaft, the conductive ring being electrically connected to a first end of the stationary electrical connection part, the insulating shaft being rotatably installed within the housing, and the conductive ring being configured to be electrically connected with the electrical device.

12. The conductive slip ring according to claim 11, wherein, the conductive ring includes an annular body and an electrical terminal disposed within the annular body, a first end of the electrical terminal being electrically connected to an inner annular surface of the annular body, the insulating shaft includes an electrical terminal clearance groove extending axially therefrom, a second end of the electrical terminal extending into the electrical terminal clearance groove and configured to be electrically connected with the electrical device, and an outer annular surface of the annular body being electrically contacted with the stationary electrical connection part.

13. The conductive slip ring according to claim 12, wherein, the first end of the electrical terminal is fixedly connected to the annular body, and the annular body, through an insertion engagement of the second end of the electrical terminal with the electrical terminal clearance groove, is in a limiting engagement with the insulating shaft in a rotational direction of the rotary electrical connection part.

14. The conductive slip ring according to claim 12, wherein, there are a plurality of conductive rings, and lengths of annular bodies of the plurality of conductive rings in an axial direction of the insulating shaft are not all equal.

15. The conductive slip ring according to claim 12, wherein, there are a plurality of conductive rings spaced apart in an axial direction on the insulating shaft, the insulating shaft having a plurality of spaced-apart electrical terminal clearance grooves, the second end of the electrical terminal of each of the conductive rings extending into a corresponding electrical terminal clearance groove, and there are a plurality of stationary electrical connection parts spaced apart in the axial direction, and each of the conductive rings electrically connecting a corresponding stationary electrical connection part to a corresponding electrical device.

16. The conductive slip ring according to claim 11, wherein, an end of the insulating shaft is rotatably disposed within the stationary insulating sleeve via a first bearing, the stationary insulating sleeve including an annular isolation protrusion fixed relative to the stationary insulating sleeve, the first bearing located on a first side of the annular isolation protrusion, the conductive ring located on a second side of the annular isolation protrusion, the first side and the second side being opposite to each other.

17. The semiconductor process equipment comprising the process chamber, the carrier, and the conductive slip ring according to any one of claims 1 to 16, wherein the carrier is rotatably disposed within the process chamber, the electrical device is disposed within the carrier, the housing being configured to be sealingly connected to the process chamber and the housing cavity communicates with the chamber space of the process chamber, and the rotary electrical connection part is connected to the carrier and electrically connected to the electrical device within the carrier.
